# EUROPÄISCHE PATENTANMELDUNG

(11) **EP 1 628 322 A1**
(43) Veröffentlichungstag der Anmeldung: **22.02.2006**
(21) Anmeldenummer: 04019521.6
(22) Anmeldetag: 17.08.2004
(51) Int. Cl.: H01J 37/32, C23C 14/50, H01J 37/34

(54) **Haltevorrichtung für eine Blende**

(71) Anmelder: Applied Films GmbH & Co. KG, 63755 Alzenau (DE)
(72) Erfinder: Sauer, Andreas, 63762 Grossoshteim (DE); Wurster, Harald, 63776 Mömbris (DE); Joos, Gerhard, 63785 Obenburg (DE); Hattendorf, Guido, 63636 Brachttal (DE)
(74) Vertreter: GROSSE BOCKHORNI SCHUMACHER

(57) **Zusammenfassung**

Eine Haltevorrichtung 12 für wenigstens eine Blende 9 zur Anordnung der Blende 9 in einer Beschichtungskammer 2 einer Vorrichtung zum Beschichten eines Substrats, insbesondere eines Glassubstrats, ist so ausgebildet, dass eine von der Haltevorrichtung 12 gehaltene Blende 9 durch die Bewegung der Haltevorrichtung 12 wenigstens von einer ersten Position innerhalb der Beschichtungskammer 2 zu einer zweiten Position bewegt werden kann. Die Haltevorrichtung 12 weist Mittel 13 derart auf, dass die Blende 9 Hindernissen auf dem Weg zwischen der ersten Position und der zweiten Position ausweichen kann. Insbesondere ist die Blende 9 bei der Bewegung von der ersten in die zweite Position verschwenkbar an der Haltevorrichtung 12 angeordnet.

## Beschreibung

Die Erfindung betrifft eine Haltevorrichtung für wenigstens eine Blende zur Anordnung der Blende in einer Beschichtungskammer einer Vorrichtung zum Beschichten eines Substrats, insbesondere eines Glassubstrats, die so ausgebildet ist, dass eine von der Haltevorrichtung gehaltene Blende durch die Bewegung der Haltevorrichtung wenigstens von einer ersten Position innerhalb der Beschichtungskammer zu einer zweiten Position bewegt werden kann.

Es ist bekannt, in Beschichtungsanlagen, beispielsweise in Glasbeschichtungsanlagen, innerhalb der Beschichtungskammer Blenden anzubringen, die für die notwendige Abschirmung bestimmter Bereiche der Kammer sorgen und zu einer gezielten und gleichmäßigen Beschichtung des Glassubstrats beitragen. Insbesondere werden Blenden im Bereich der Kathoden der Glasbeschichtungsanlage angeordnet. Dies gilt sowohl für den Betrieb mit planaren als auch mit rotierenden Kathodenkörpern.

Um die Blenden zur Wartung oder zur Reinigung aus der Beschichtungskammer entnehmen zu können, ist in der Beschichtungskammer, meist im Bereich über den Kathoden, eine Zugriffsöffnung vorgesehen. Durch diese Zugriffsöffnung können die Kathoden ausgewechselt werden. Zudem kann auf die übrigen Komponenten der Beschichtungsanlage, insbesondere auf die Blenden, bei Bedarf zugegriffen werden.

Häufig ist jedoch wenigstens ein Abschnitt der Blenden, von der Zugriffsöffnung aus gesehen, unterhalb einer Kathode, also im Raum zwischen den Kathoden und dem Substrat, angeordnet. Dieser Abschnitt kann eine Störkante mit der davor angeordneten Kathode ausbilden. Aus diesem Grund ergibt sich bei fest eingebauten oder an einem Rahmen befestigen Blenden das Problem, dass die Blenden erst nach dem Entfernen der Kathodenkörper entnommen werden können. Ein Zugriff auf Blenden, die die Kathoden teilweise umschließen, ist also lediglich nach oder gleichzeitig mit dem Ausbau der Kathoden aus der Beschichtungskammer möglich. Dies wirkt sich negativ auf eine effiziente Nutzung der Anlage aus, da zusätzlicher Montage- und Zeitaufwand entsteht.

Besondere Nachteile ergeben sich bei der Verwendung von sogenannten Cantilevered Kathoden, da diese Kathoden seitlich durch die Rezipientenwand montiert werden, und nach dem Öffnen der Beschichtungskammer in dieser verbleiben. Eine Target- oder Kathodenmontage, die einem Blendenwechsel vorausgehen muss, ist hier besonders aufwendig.

Ausgehend davon ist es die Aufgabe der vorliegenden Erfindung, die Entnahme der Blenden aus einer Beschichtungsanlage zu erleichtern. Insbesondere gilt dies für die Entnahme von Blenden, die die Kathoden wenigstens teilweise umgreifen.

Diese Aufgabe wird gelöst durch die Bereitstellung einer Haltevorrichtung für eine Blende mit den Merkmalen des Anspruchs 1.

Die erfindungsgemäße Haltevorrichtung für wenigstens eine Blende zur Anordnung der Blende in einer Beschichtungskammer einer Vorrichtung zum Beschichten eines Substrats, insbesondere eines Glassubstrats, ist so ausgebildet, dass eine von der Haltevorrichtung gehaltene Blende durch die Bewegung der Haltevorrichtung wenigstens von einer ersten Position innerhalb der Beschichtungskammer zu einer zweiten Position bewegt werden kann. Die Haltevorrichtung weist Mittel derart auf, dass die Blende Hindernissen auf dem Weg zwischen der ersten Position und der zweiten Position ausweichen kann.

Die bewegbare Haltevorrichtung erlaubt es, die mit ihr verbundene Blende aus der Beschichtungskammer zu entnehmen. Die Haltevorrichtung ist üblicherweise so ausgebildet, dass sich ein Abschnitt bis in den Bereich der Zugriffsöffnung erstreckt und unter Umständen mit dem Abdeckflansch zum Verschließen der Zugriffsöffnung verbunden ist. In letzterem Fall werden die Blenden mit dem Abheben des Flansches von der Öffnung von ihrer Betriebsposition weg bewegt.

Da in der Regel auch eine teilweise Abschirmung durch die Blenden in Richtung des Substrats, also auf der der Zugriffsöffnung abgewandten Seite, erforderlich ist, befindet sich ein Abschnitt der Blenden, von der Zugriffsöffnung aus gesehen, unterhalb einer Kathode. Dieser Teil der Blenden bildet in der Betriebsposition mit der Kathode eine Störkante, die bei geradlinigem Herausziehen einer herkömmlichen Halterung aus der Kammer mit der davor angeordneten Kathode kollidieren würde.

Durch den Einsatz der erfindungsgemäßen Haltevorrichtung wird ein Kontakt der Blenden mit den Kathoden, den Kammerwänden und möglicherweise mit anderen in der Kammer angeordneten Komponenten der Beschichtungsanlage beim Herausnehmen der Blenden aus der Beschichtungskammer verhindert. Damit kann, ohne einen Ausbau der Kathoden aus der Beschichtungskammer, gewährleistet werden, dass es beim Herausnehmen der Blenden zu keinen Beschädigungen der Blenden oder der Kathoden kommen kann. Trotz eines Hintergreifens der Kathode durch die Blenden wird eine Beschädigung bzw. ein Verklemmen der Blenden ausgeschlossen, da die Haltevorrichtung dafür sorgt, dass die Blende die im Bereich ihrer Bahn liegenden Hindernisse nicht berührt.

Die aus der Beschichtungskammer herausgenommenen Blenden können dann bequem von der Halterung abmontiert und gewartet oder gereinigt werden. Ein aufwendiger Ausbau der Kathoden vor der Entnahme der Blenden ist nicht notwendig. Durch die Ersparnis von Montageaufwand und Zeit kann eine effizientere Nutzung der Anlage erreicht werden.

Bevorzugt sind die Mittel so ausgebildet, dass die Blende bei der Bewegung der Blende von der ersten Position in die zweite Position relativ zur Haltevorrichtung wenigstens eine weitere Bewegung durchführen kann.

Die zusätzliche, der Bewegung der Blende beim Entnehmen aus der Beschichtungskammer überlagerte Bewegung, kann eine Rotationsbewegung oder eine translatorische Bewegung sein. Durch diese zusätzliche Bewegung weicht die Blende auf ihrem Weg aus der Betriebsposition zur Öffnung hin möglichen Hindernissen, beispielsweise einer Kathode, mit der sie in der Betriebsposition eine Störkante ausbildet, aus.

Insbesondere sind die Mittel so ausgebildet, dass die Blende auf dem Weg zwischen der ersten Position und der zweiten Position ihre Ausrichtung in der Beschichtungskammer ändern kann. Dies bedeutet, dass die Blende gegenüber ihrer ursprünglichen Betriebsposition verkippt werden kann. Auf diese Weise kann bei einer gesteuerten und gezielten Änderung der Ausrichtung während des Passierens eines Hindernisses ein Kontakt mit diesem vermieden werden.

Die Mittel sind insbesondere zum Verschwenken der Blende relativ zur Haltevorrichtung ausgebildet. Auf diese Weise kann, beispielsweise beim Passieren der Kathode während des Herausziehens der Haltevorrichtung aus der Beschichtungskammer, ein sich in der Betriebsposition der Blende hinter der Kathode befindender Überstand durch ein Verkippen der Blende ohne Berührung der Kathode an dieser vorbei gerührt werden.

Die Mittel können beispielsweise ein Drehgelenk zum Verschwenken der Blende umfassen.

Die Blende kann insbesondere an einem verschwenkbaren Teilstück der Haltevorrichtung befestigt sein. Dies bedeutet, dass die Haltevorrichtung aus zwei Teilen besteht, die über eine Drehachse miteinander verbunden sind. Ein Teil kann dann mit dem Abdeckflansch zum Verschließen der Öffnung verbunden sein, während an dem anderen Teil die Blende befestigt ist.

Die Mittel können alternativ so ausgebildet sein, dass die Blende auf dem Weg zwischen der ersten Position und der zweiten Position eine seitliche Verschiebung der Blende gegenüber der Haltevorrichtung ausführen kann. Dies bedeutet, dass die Blende einem Hindernis dadurch ausweichen kann, dass sie sich auf der Haltevorrichtung seitlich, in der Regel senkrecht zur Bewegungsrichtung zwischen der ersten und der zweiten Position, vom Hindernis weg bewegt. Welche Ausführungsform gewählt wird, hängt unter anderem von der Anordnung der Komponenten in der Kammer ab.

Die Mittel sind bevorzugt so ausgebildet, dass die Ausrichtung und/oder die seitliche Verschiebung der Blende von der Position der Blende auf dem Weg zwischen der ersten Position und der zweiten Position abhängt. Durch den Zusammenhang zwischen der Position der Blende, insbesondere ihrem Abstand von der Zugriffsöffnung (entsprechend ihrer Höhenlage), und dem Grad ihrer Verschwenkung bzw. Verschiebung wird in jeder Phase der Bewegung zur zweiten Position verhindert, dass eine Kollision mit einem Hindernis stattfinden kann. Der Ort der Blende kann auf unterschiedliche Weise ermittelt und die entsprechende Einstellung der Ausweichmittel gewählt werden.

Die Änderung der Ausrichtung und/oder die seitliche Verschiebung der Blende kann beispielsweise mechanisch, insbesondere durch die Einwirkung der Schwerkraft oder einer Federkraft, erfolgen. So kann alleine ein Anheben der Blende von einer Auflagefläche, beispielsweise der Kontaktfläche mit einer Kühlung, zu einer Verschwenkung weg von der Kathode führen. Dazu muss lediglich der Schwerpunkt der Blende so gewählt werden, dass beim Anheben der Haltevorrichtung ein geeignetes Drehmoment auf die Blende wirkt, so dass eine Verschwenkung um einen gewünschten Winkel um die Drehachse stattfindet. Diese Anordnung ist besonders einfach und kostengünstig in der Herstellung und im Betrieb. Es muss keine Energie von außen zugeführt und nicht von außen gesteuert werden.

Die Änderung der Ausrichtung und/oder die seitliche Verschiebung der Blende kann wahlweise auch elektronisch erfolgen.

Die Änderung der Ausrichtung und/oder die seitliche Verschiebung der Blende bei der Bewegung der Blende von der ersten Position in die zweite Position erfolgt bevorzugt selbsttätig. Dies kann zum Beispiel durch das Hochheben von einer Auflagefläche und die Einwirkung der Schwerkraft, durch eine automatische Aktivierung einer Feder an einem bestimmten Streckenpunkt, durch eine Führung der Blende, durch automatische Betätigung eines Schalters beim Durchgang einer bestimmten Zone, oder durch andere dem Fachmann geläufige Methoden bewerkstelligt werden.

Die Änderung der Ausrichtung und/oder die seitliche Verschiebung der Blende wird insbesondere durch die Bewegung der Blende von der ersten Position in die zweite Position erzwungen. Die Blende ist in ihrer Bewegungsfreiheit beim Passieren eines Hindernisses beschränkt.

Die Änderung der Ausrichtung und/oder die seitliche Verschiebung der Blende während der Bewegung der Blende von der ersten Position in die zweite Position erfolgt bevorzugt automatisch. Unter dem Begriff automatisch soll in diesem Zusammenhang jede Änderung verstanden werden, die ohne Eingreifen durch den Benutzer vor sich geht. Ein Versagen des Systems auf Grund menschlicher Fehler oder Nachlässigkeiten wird so ausgeschlossen.

Die erste Position ist in der Regel eine für den Betrieb der Vorrichtung zum Beschichten vorgesehene Betriebsposition innerhalb der Beschichtungskammer.

Die zweite Position ist in der Regel eine Wartungsposition mit einem im wesentlichen freien Zugriff auf die Blende. Sie kann sich innerhalb oder außerhalb der Beschichtungskammer befinden. Die zweite Position kann eine Position nahe einer Zugangsöffnung der Beschichtungskammer oder außerhalb der Beschichtungskammer sein.

Die Haltevorrichtung wird insbesondere bei der Bewegung der Blende von der ersten zur zweiten Position eine im wesentlichen geradlinige Bewegung durchführen. Ist die Haltevorrichtung beispielsweise am Flansch zum Verschließen der Öffnung befestigt, so bewirkt ein senkrechtes Anheben des Flansches beim Öffnen eine im wesentlichen geradlinige Bewegung der Halterung. Die Störkanten sind damit eindeutig definiert und die Blende kann automatisch die richtigen Bewegungen relativ zur Haltevorrichtung durchführen, um Kollisionen zu verhindern.

Die in der ersten Position angeordnete Blende kann eine innerhalb der Beschichtungskammer angeordnete Kathode wenigstens teilweise umgreifen. Insbesondere wird die Kathode hintergriffen, so dass Störkanten entstehen, die allerdings durch die erfindungsgemäße Vorrichtung beim Entfernen der Blende durch die zusätzliche Bewegung der Blende relativ zur Haltevorrichtung beseitigt werden.

Die in der ersten Position angeordnete Blende kann bevorzugt mit einer Kühlung in Kontakt stehen. Die beim Beschichtungsprozess entstehende Wärme kann durch eine entsprechende Kühlung abgeführt werden. Die Kühlung wird in der Regel eine Wasserkühlung sein. Ein Teil der Blende kann auf einer Kühlfläche aufliegen, so dass ein möglichst guter thermischer Kontakt entsteht. Dieser Kontakt kann beispielsweise durch das Deckelgewicht, oder bei Evakuierung der Beschichtungsanlage durch den Differenzdruck erreicht werden. Dadurch entsteht eine ausreichende Anpresskraft. Um eine relativ gleichmäßig Anpressung zu erreichen und um den Anpressdruck zu regulieren, können zusätzlich Federn verwendet werden.

Die Blende löst sich bevorzugt bei der Bewegung von der ersten Position in die zweite Position von der Kühlung. Die Wasserkühlung kann prinzipiell mit den Blenden fest verbunden sein. Sie muss dann zusammen mit den Blenden aus der Beschichtungskammer entfernt werden. Die Kühlung kann jedoch auch in der Anlage belassen werden, sofern die Wasserkühlung nur in Kontakt mit der Blende steht. Bei dieser Ausführungsform können die Blenden zur Reinigung sehr schnell gewechselt werden, da sie mit einfachen Scharnierbolzen befestigt sein können, während sie in herkömmlichen Anlagen mit einer Vielzahl von Schrauben mit der Kühlung verbunden sind.

Weitere Merkmale und Vorteile der Erfindung ergeben sich aus der nachfolgenden Beschreibung eines speziellen Ausführungsbeispiels. Es zeigen:
- Fig. 1: einen Teil einer Beschichtungsanlage mit verschiedenen Komponenten in der Betriebsposition in einer senkrechten Schnittansicht; und
- Fig. 2: die Anlage beim Öffnen der Beschichtungskammer.

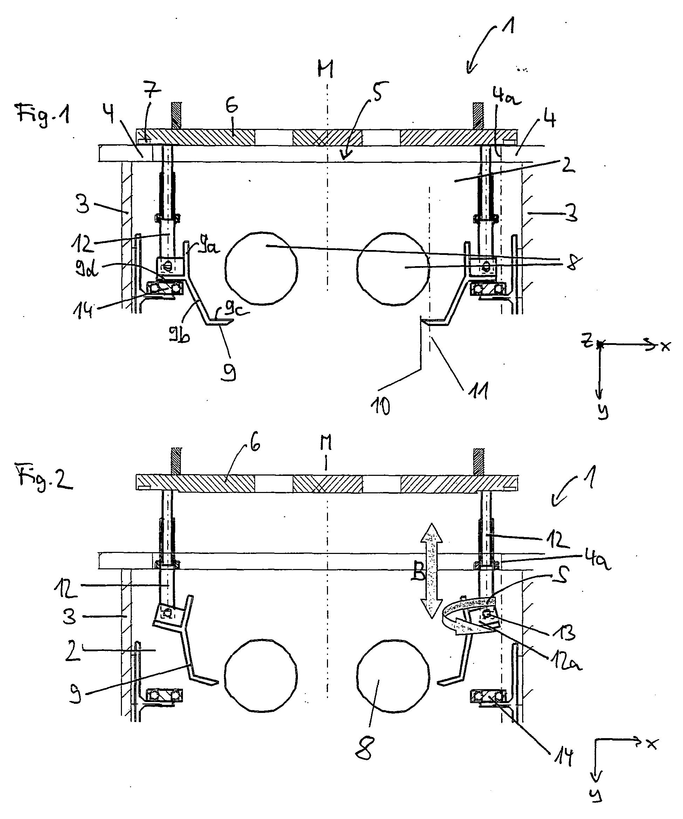

In Figur 1 ist ein Teil einer Beschichtungsanlage 1 dargestellt. Sie weist eine Beschichtungskammer 2 mit Seitenwänden 3 und einem oberen Wandbereich 4 auf. Der obere Wandbereich 4 wird von einer Zugangsöffnung 5 durchbrochen, die einen Zugriff in die Beschichtungskammer 2 ermöglicht. Insbesondere dient die Zugangsöffnung 5 dem Zugriff zum Auswechseln der Kathodenkörper 8 und zur Wartung der übrigen Komponenten der Beschichtungsanlage 1, insbesondere der Blenden 9. Die Zugangsöffnung 5 ist daher im Bereich der Kathodenkörper 8 und der Blenden 9 vorgesehen.

Die Zugangsöffnung 5 ist während des Betriebs der Beschichtungsanlage 1, wie in Figur 1 dargestellt, mit einem Abdeckflansch 6 verschlossen. In Nuten angeordnete Dichtungen 7, beispielsweise Dichtringe, sorgen für einen vakuumdichten Verschluss der Beschichtungskammer 2.

In dem Ausführungsbeispiel sind in der Beschichtungskammer 2 zwei Kathodenkörper 8, die als rotierende Kathoden ausgebildet sind, vorgesehen. Die Kathodenkörper 8 weisen eine im wesentlichen zylindrische Form auf. Es ist jedoch klar, dass statt der rotierenden auch planare Kathoden in der Beschichtungskammer 2 eingesetzt werden können.

Die Blende 9 ist im dargestellten Schnitt in der senkrechten x-y-Ebene gewinkelt ausgebildet. Ein Abschnitt 9a der Blende ist parallel zur y-Achse ausgebildet, ein sich anschließender Abschnitt 9b ist in Richtung des Targets 8 geneigt, und ein Abschnitt 9c weist parallel zur x-Achse in die Richtung der Mittelachse M. Auf diese Weise wird das Target 8 von der zugehörigen Blende 9 teilweise umgriffen.

Jeder der Kathodenkörper 8 wird seitlich in Richtung parallel zur x-Achse vom Abschnitt 9a, 9b der Blende 9 abgeschirmt. Zusätzlich wird die Kathode 8 durch den Abschnitt 9c der Blende 9 zu einem kleinen Teil auch nach unten hin in Substratrichtung (d.h. in y-Richtung) abgeschirmt. Von oben, also von der Zugangsöffnung 5 aus gesehen, ist der zum freien Ende der Blende 9 weisende Teil des Abschnitts 9c im Betriebszustand hinter einem Kathodenkörper 8 angeordnet, wodurch ein Überstand 10 über eine zur y-Achse parallele Störkante 11 der Kathode 8 gebildet wird.

Die in der Betriebsposition angeordnete Blende 9 steht über einen Flansch 9d mit einer Wasserkühlung 14 in Kontakt. Die beim Beschichtungsprozess entstehende Wärme kann durch die Kühlung 14 abgeführt werden. Durch eine feste Auflage wird ein guter thermischer Kontakt zwischen der Blende 9 und der Kühlung 14 erreicht. Der Kontakt kann beispielsweise durch das Gewicht des Flansches 6, oder bei evakuierter Beschichtungskammer 2 durch den Differenzdruck erreicht werden.

In Figur 2 ist die Beschichtungsanlage 1 während des Öffnens der Beschichtungskammer 2 durch Abnehmen des Abdeckflansches 6 gezeigt. Der Abdeckflansch 6 kann in den durch den Pfeil B angedeuteten Richtungen angehoben bzw. abgesenkt werden.

Die Halterungen 12 sind mit dem Abdeckflansch 6 verbunden. So bewegen sich bei einem senkrechten Anheben des Abdeckflansches 6 die Halterungen 12 geradlinig senkrecht nach oben mit.

Mit der Bewegung des Abdeckflansches 6 und der Halterung 12 nach oben wird die Blende 9, die in ihrer Betriebsposition auf der Kontaktfläche der Kühlung 14 aufliegt, von der Kontaktfläche in Richtung der Öffnung 5 angehoben.

Der in der Figur 1 eingezeichnete Überstand 10 des Blendenabschnitts 9c über die Störkante 11 der Kathode 8 hinaus in Richtung der Mittelachse M würde bei einer vollkommen starren Verbindung zwischen dem Abdeckflansch 6 und der Blende 9 während der Aufwärtsbewegung mit dem Kathodenkörper 8 kollidieren. Eine Kollision oder auch ein Kontakt mit dem Kathodenkörper 8 könnte das Herausnehmen der Blende 9 aus der Beschichtungskammer 2 verhindern und zudem zu Beschädigungen führen.

Aus diesem Grund sind die Haltevorrichtungen 12 mit einem Gelenk, beispielsweise einem Drehzapfen 13, ausgestattet. Ein Teil der Halterung 12 ist am oberen Ende am Flansch 6 befestigt. Der andere Teil 12a der Halterung 12 ist starr mit der Blende 9 verbunden. Der Teil 12a ist dabei in einem durch die Abschnitte 9a und 9d der Blende 9 gebildeten Winkel angeordnet.

Die beiden Teile der Haltevorrichtung 12 sind miteinander über ein Drehgelenk, beispielsweise über einen Drehzapfen 13, verbunden und somit relativ zueinender verschwenkbar. Die Drehachse ist in der Zeichnung senkrecht zur x-y-Ebene ausgerichtet.

Beim Anheben des Abdeckflansches 6 wird, wie bereits oben beschrieben, die Blende 9 von der Kontaktfläche der Kühlung 14 angehoben. Die Anordnung wurde so ausgelegt, dass der Schwerpunkt des Verbundes aus Blende 9 und dem Teil 12a der Halterung 12 bezüglich der Drehachse 13 zur Mittelachse M hin versetzt ist. Beim Anheben der Blende wirkt daher die Schwerkraft seitlich versetzt von der Drehachse auf den Verbund 9, 12a ein und übt ein Drehmoment aus, so dass auf den Verbund 9, 12a nach unten hin verschwenkt wird. In der Figur 2 ist die Richtung der Verschwenkung durch den Pfeil S angedeutet. Damit wird die Blende 9 insgesamt nach außen von der Mittelachse M und der Kathode 8 weg in der x-y-Ebene so weit verschwenkt, dass der Überstand 10 mit der Kathode beseitigt wird. Die Blende 9 kann folglich die Kathode 8 ohne Berührung passieren. Die Drehung ist außerdem so bemessen, dass der Verbund aus Blende 9 und dem Teil 12a ohne Kontakt mit der Kante 4a der oberen Wand 4 durch die Öffnung 5 geführt werden kann. Auf diese Weise können die Blenden 9 sicher und ohne vorherigen Ausbau der Kathodenkörper 8 aus der Beschichtungskammer 2 entfernt werden.

Die Drehung des Teils 12a wurde in dem Beispiel durch die Schwerkraft bewirkt. Alternativ können jedoch auch Federkräfte oder sonstige mechanische oder elektronische Hilfsmittel verwendet werden, um eine erzwungene, automatische oder jedenfalls selbsttätige Bewegung der Blende 9 relativ zum oberen Teil der Halterung 12 zur Verhinderung einer Kollision mit der Kathode 8 zu erreichen. Beispielsweise könnte eine Steuerung mitwirken, die eine Schwenkbewegung S in Abhängigkeit von der Translationsbewegung B so koordiniert, dass die Blende 9 ohne Kollision mit dem Kathodenkörper 8 oder einer Komponente der Beschichtungsanlage 1 zur Zugriffsöffnung 5 geführt werden kann. Der Mechanismus zur Durchführung der Verschwenkung S in Abhängigkeit von der translatorischen Bewegung B könnte beispielsweise koordiniert in Abhängigkeit von der y-Koordinate des Drehzapfens 13 erfolgen, wobei vorzugsweise bestimmten y-Koordinaten bestimmte Schwenkwinkel zugeordnet sind. Das Verschwenken der Blende 9 um den Drehzapfen 13 wird bei einer Bewegung B der Halterungen 12 erzwungen, d.h. die Verschwenkung S erfolgt automatisch mit der Bewegung B. Damit werden menschliche Fehler beim Entfernen der Blenden 9 aus der Beschichtungskammer 2 und Beschädigungen von Komponenten der Anlage 1 weitgehend ausgeschlossen. Sowohl die Steuerung als auch die Schwenkbewegung selbst können sowohl mechanisch als auch elektronisch erfolgen.

Die während des Beschichtungsprozesses an der Blende 9 entstehende Wärme wird durch das Kühlelement 14 abgeführt. Die Wasserkühlung 14 kann, wie in Figur 2 gezeigt, beim Herausnehmen der Blenden 9 in der Beschichtungskammer zurück bleiben. Die Blende 9 löst sich im Ausführungsbeispiel beim Abheben von der Kontaktfläche der Kühlung 14 vom Kühlelement. Ein guter thermischer Kontakt zwischen der Kühlung 14 und der Blende 9, insbesondere zwischen der Kühlung 14 und dem Abschnitt 9d der Blende 9, wird durch eine hohe und ausgeglichene Anpresskraft gewährleistet. Bevorzugt kann die Länge der Halterung 12 einstellbar sein. Zudem kann die Halterung 12 mit Federn zur Regulierung des Anpressdrucks ausgestattet sein, die eine gleichmäßige Anpressung des Blendenabschnitts 9d erzeugen.

Die Wasserkühlung 14 kann jedoch prinzipiell auch mit den Blenden 9 fest verbunden sein, um mit diesen zusammen aus der Beschichtungskammer 2 herausgenommen zu werden.

Die gezeigte Beschichtungsanlage bietet die Möglichkeit, die Blenden 9 zur Reinigung oder zur Wartung schnell zu wechseln, insbesondere ohne einen Ausbau der Kathodenkörper 8.

### Bezugszeichenliste:

- 1: Beschichtungsanlage
- 2: Beschichtungskammer
- 3: Seitenwände
- 4: oberer Wandbereich
- 4a: Kante des Wandbereichs
- 5: Zugangsöffnung
- 6: Abdeckflansch
- 7: Dichtung
- 8: Kathodenkörper
- 9: Blende
- 9a-9d: Abschnitte der Blende
- 10: Überstand
- 11: Störkante der Kathode
- 12: Halterung
- 12a: unterer Teil der Halterung
- 13: Drehzapfen
- 14: Wasserkühlung
- M: Mittelachse
- B: Bewegungsrichtung
- S: Verschwenkung

## Patentansprüche

1. Haltevorrichtung (12) für wenigstens eine Blende (9) zur Anordnung der Blende (9) in einer Beschichtungskammer (2) einer Vorrichtung zum Beschichten eines Substrats, insbesondere eines Glassubstrats, die so ausgebildet ist, dass eine von der Haltevorrichtung (12) gehaltene Blende (9) durch die Bewegung der Haltevorrichtung (12) wenigstens von einer ersten Position innerhalb der Beschichtungskammer (2) zu einer zweiten Position bewegt werden kann, **dadurch gekennzeichnet, dass**
die Haltevorrichtung (12) Mittel (13) derart aufweist, dass die Blende (9) Hindernissen auf dem Weg zwischen der ersten Position und der zweiten Position ausweichen kann.

2. Haltevorrichtung (12) nach Anspruch 1, **dadurch gekennzeichnet, dass**
die Mittel (13) so ausgebildet sind, dass die Blende (9) bei der Bewegung der Blende (9) von der ersten Position in die zweite Position relativ zur Haltevorrichtung (12) wenigstens eine weitere Bewegung durchführen kann.

3. Haltevorrichtung (12) nach Anspruch 1 oder 2, **dadurch gekennzeichnet, dass**
die Mittel (13) so ausgebildet sind, dass die Blende (9) auf dem Weg zwischen der ersten Position und der zweiten Position ihre Ausrichtung in der Beschichtungskammer (2) ändern kann.

4. Haltevorrichtung (12) nach einem der vorhergehenden Ansprüche, **dadurch gekennzeichnet, dass**
die Mittel (13) zum Verschwenken der Blende (9) relativ zur Haltevorrichtung (12) ausgebildet sind.

5. Haltevorrichtung (12) nach Anspruch 4, **dadurch gekennzeichnet, dass**
die Mittel (13) ein Drehgelenk (13) zum Verschwenken der Blende (9) umfassen.

6. Haltevorrichtung (12) nach Anspruch 5, **dadurch gekennzeichnet, dass**
die Blende (9) an einem verschwenkbaren Teilstück (12a) der Haltevorrichtung (12) befestigt ist.

7. Haltevorrichtung (12) nach einem der vorhergehenden Ansprüche, **dadurch gekennzeichnet, dass**
die Mittel (12a) so ausgebildet sind, dass die Blende (9) auf dem Weg zwischen der ersten Position und der zweiten Position eine seitliche Verschiebung der Blende (9) gegenüber der Haltevorrichtung (12) ausführen kann.

8. Haltevorrichtung (12) nach einem der vorhergehenden Ansprüche, **dadurch gekennzeichnet, dass**
die Mittel (13) so ausgebildet sind, dass die Ausrichtung und/oder die seitliche Verschiebung der Blende (9) von der Position der Blende (9) auf dem Weg zwischen der ersten Position und der zweiten Position abhängt.

9. Haltevorrichtung (12) nach einem der vorhergehenden Ansprüche 3 bis 8, **dadurch gekennzeichnet, dass**
die Änderung der Ausrichtung und/oder die seitliche Verschiebung der Blende (9) mechanisch, insbesondere durch die Einwirkung der Schwerkraft oder einer Federkraft, erfolgt.

10. Haltevorrichtung (12) nach einem der vorhergehenden Ansprüche 3 bis 8, **dadurch gekennzeichnet, dass**
die Änderung der Ausrichtung und/oder die seitliche Verschiebung der Blende (9) elektronisch erfolgt.

11. Haltevorrichtung (12) nach einem der vorhergehenden Ansprüche 3 bis 10, **dadurch gekennzeichnet, dass**
die Änderung der Ausrichtung und/oder die seitliche Verschiebung der Blende (9) bei der Bewegung der Blende (9) von der ersten Position in die zweite Position selbsttätig erfolgt.

12. Haltevorrichtung (12) nach einem der vorhergehenden Ansprüche 3 bis 11, **dadurch gekennzeichnet, dass**
die Änderung der Ausrichtung und/oder die seitliche Verschiebung der Blende (9) durch die Bewegung der Blende (9) von der ersten Position in die zweite Position erzwungen wird.

13. Haltevorrichtung (12) nach einem der vorhergehenden Ansprüche 3 bis 12, **dadurch gekennzeichnet, dass**
die Änderung der Ausrichtung und/oder die seitliche Verschiebung der Blende (9) während der Bewegung der Blende (9) von der ersten Position in die zweite Position automatisch erfolgt.

14. Haltevorrichtung (12) nach einem der vorhergehenden Ansprüche, **dadurch gekennzeichnet, dass**
die erste Position eine für den Betrieb der Vorrichtung zum Beschichten vorgesehene Betriebsposition innerhalb der Beschichtungskammer (2) ist.

15. Haltevorrichtung (12) nach einem der vorhergehenden Ansprüche, **dadurch gekennzeichnet, dass**
die zweite Position eine Wartungsposition mit einem im wesentlichen freien Zugriff auf die Blende (9) ist.

16. Haltevorrichtung (12) nach Anspruch 15, **dadurch gekennzeichnet, dass**
die zweite Position eine Position nahe einer Zugangsöffnung (5) der Beschichtungskammer (2) oder außerhalb der Beschichtungskammer (2) ist.

17. Haltevorrichtung (12) nach einem der vorhergehenden Ansprüche, **dadurch gekennzeichnet, dass**
sich die Haltevorrichtung (12) bei der Bewegung der Blende (9) von der ersten zur zweiten Position eine im wesentlichen geradlinige Bewegung durchführt.

18. Haltevorrichtung (12) nach einem der vorhergehenden Ansprüche, **dadurch gekennzeichnet, dass**
die in der ersten Position angeordnete Blende (9) eine innerhalb der Beschichtungskammer (2) angeordnete Kathode (8) wenigstens teilweise umgreift.

19. Haltevorrichtung (12) nach einem der vorhergehenden Ansprüche, **dadurch gekennzeichnet, dass**
die in der ersten Position angeordnete Blende (9) mit einer Kühlung (14) in Kontakt steht.

20. Haltevorrichtung (12) nach Anspruch 19, **dadurch gekennzeichnet, dass**
sich die Blende (9) bei der Bewegung von der ersten Position in die zweite Position von der Kühlung (14) löst.

## Geänderte Patentansprüche

### Geänderte Patentansprüche gemäss Regel 86(2) EPÜ.

**1.** Haltevorrichtung (12) für wenigstens eine Blende (9) zur Anordnung der Blende (9) in einer Beschichtungskammer (2) einer Vorrichtung zum Beschichten eines Substrats, insbesondere eines Glassubstrats, die so ausgebildet ist, dass eine von der Haltevorrichtung (12) gehaltene Blende (9) durch die Bewegung der Haltevorrichtung (12) wenigstens von ihrer Betriebsposition innerhalb der Beschichtungskammer (2) aus der Beschichtungskammer (2) heraus bewegt werden kann, **dadurch gekennzeichnet, dass**
die Haltevorrichtung (12) Mittel (13) derart aufweist, dass die Blende (9) Hindernissen auf dem Weg beim Herausnehmen der Blende aus der Beschichtungskammer (2) ausweichen kann.

**2.** Haltevorrichtung (12) nach Anspruch 1, **dadurch gekennzeichnet, dass**
die Mittel (13) so ausgebildet sind, dass die Blende (9) bei der Bewegung der Blende (9) von der Betriebsposition aus der Beschichtungskammer (2) heraus relativ zur Haltevorrichtung (12) wenigstens eine weitere Bewegung durchführen kann.

**3.** Haltevorrichtung (12) nach Anspruch 1 oder 2, **dadurch gekennzeichnet, dass**
die Mittel (13) so ausgebildet sind, dass die Blende (9) auf dem Weg von der Betriebsposition aus der Beschichtungskammer (2) heraus ihre Ausrichtung in der Beschichtungskammer (2) ändern kann.

**4.** Haltevorrichtung (12) nach einem der vorhergehenden Ansprüche, **dadurch gekennzeichnet, dass**
die Mittel (13) zum Verschwenken der Blende (9) relativ zur Haltevorrichtung (12) ausgebildet sind.

**5.** Haltevorrichtung (12) nach Anspruch 4, **dadurch gekennzeichnet, dass**
die Mittel (13) ein Drehgelenk (13) zum Verschwenken der Blende (9) umfassen.

**6.** Haltevorrichtung (12) nach Anspruch 5, **dadurch gekennzeichnet, dass**
die Blende (9) an einem verschwenkbaren Teilstück (12a) der Haltevorrichtung (12) befestigt ist.

**7.** Haltevorrichtung (12) nach einem der vorhergehenden Ansprüche, **dadurch gekennzeichnet, dass**
die Mittel (12a) so ausgebildet sind, dass die Blende (9) auf dem Weg von der Betriebsposition aus der Beschichtungskammer (2) heraus eine seitliche Verschiebung der Blende (9) gegenüber der Haltevorrichtung (12) ausführen kann.

**8.** Haltevorrichtung (12) nach einem der vorhergehenden Ansprüche, **dadurch gekennzeichnet, dass**
die Mittel (13) so ausgebildet sind, dass die Ausrichtung und/oder die seitliche Verschiebung der Blende (9) von der Position der Blende (9) auf dem Weg von der Betriebsposition aus der Beschichtungskammer (2) heraus abhängt.

**9.** Haltevorrichtung (12) nach einem der vorhergehenden Ansprüche 3 bis 8, **dadurch gekennzeichnet, dass**
die Änderung der Ausrichtung und/oder die seitliche Verschiebung der Blende (9) mechanisch, insbesondere durch die Einwirkung der Schwerkraft oder einer Federkraft, erfolgt.

**10.** Haltevorrichtung (12) nach einem der vorhergehenden Ansprüche 3 bis 8, **dadurch gekennzeichnet, dass**
die Änderung der Ausrichtung und/oder die seitliche Verschiebung der Blende (9) elektronisch erfolgt.

**11.** Haltevorrichtung (12) nach einem der vorhergehenden Ansprüche 3 bis 10, **dadurch gekennzeichnet, dass**
die Änderung der Ausrichtung und/oder die seitliche Verschiebung der Blende (9) bei der Bewegung der Blende (9) von der Betriebsposition aus der Beschichtungskammer (2) heraus selbsttätig erfolgt.

**12.** Haltevorrichtung (12) nach einem der vorhergehenden Ansprüche 3 bis 11, **dadurch gekennzeichnet, dass**
die Änderung der Ausrichtung und/oder die seitliche Verschiebung der Blende (9) durch die Bewegung der Blende (9) von der Betriebsposition aus der Beschichtungskammer (2) heraus erzwungen wird.

**13.** Haltevorrichtung (12) nach einem der vorhergehenden Ansprüche 3 bis 12, **dadurch gekennzeichnet, dass**
die Änderung der Ausrichtung und/oder die seitliche Verschiebung der Blende (9) während der Bewegung der Blende (9) von der Betriebsposition aus der Beschichtungskammer (2) heraus automatisch erfolgt.

**14.** Haltevorrichtung (12) nach einem der vorhergehenden Ansprüche, **dadurch gekennzeichnet, dass**
die Betriebsposition eine für den Betrieb der Vorrichtung zum Beschichten vorgesehene Position innerhalb der Beschichtungskammer (2) ist.

**15.** Haltevorrichtung (12) nach einem der vorhergehenden Ansprüche, **dadurch gekennzeichnet, dass**
die Blende (9) bei der Bewegung von der Betriebsposition aus der Beschichtungskammer (2) heraus in eine Wartungsposition mit einem im wesentlichen freien Zugriff auf die Blende (9) bewegt wird.

**16.** Haltevorrichtung (12) nach Anspruch 15, **dadurch gekennzeichnet, dass**
die Wartungsposition eine Position nahe einer Zugangsöffnung (5) zur Beschichtungskammer (2) oder außerhalb der Beschichtungskammer (2) ist.

**17.** Haltevorrichtung (12) nach einem der vorhergehenden Ansprüche, **dadurch gekennzeichnet, dass**
die Haltevorrichtung (12) bei der Bewegung der Blende (9) von der Betriebsposition aus der Beschichtungskammer (2) heraus eine im wesentlichen geradlinige Bewegung durchführt.

**18.** Haltevorrichtung (12) nach einem der vorhergehenden Ansprüche, **dadurch gekennzeichnet, dass**
die in der Betriebsposition angeordnete Blende (9) eine innerhalb der Beschichtungskammer (2) angeordnete Kathode (8) wenigstens teilweise umgreift.

**19.** Haltevorrichtung (12) nach einem der vorhergehenden Ansprüche, **dadurch gekennzeichnet, dass**
die in der Betriebsposition angeordnete Blende (9) mit einer Kühlung (14) in Kontakt steht.

**20.** Haltevorrichtung (12) nach Anspruch 19, **dadurch gekennzeichnet, dass**
sich die Blende (9) bei der Bewegung von der Betriebsposition aus der Beschichtungskammer (2) heraus von der Kühlung (14) löst.
